Europäisches Patentamt

European Patent Office

Office européen des brevets

(19)

(11) Veröffentlichungsnummer: **0 141 075**
**B1**

(12) **EUROPÄISCHE PATENTSCHRIFT**

(45) Veröffentlichungstag der Patentschrift:
**07.01.88**

(21) Anmeldenummer: **84109364.4**

(22) Anmeldetag: **07.08.84**

(51) Int. Cl.⁴: **H 01 L 29/72, H 01 L 29/08**

(54) **Leistungstransistor.**

(30) Priorität: **12.08.83 DE 3329241**

(43) Veröffentlichungstag der Anmeldung:
**15.05.85 Patentblatt 85/20**

(45) Bekanntmachung des Hinweises auf die Patenterteilung:
**07.01.88 Patentblatt 88/1**

(84) Benannte Vertragsstaaten:
**CH DE FR GB IT LI**

(56) Entgegenhaltungen:
**FR - A - 1 527 430**
**FR - A - 2 011 431**
**US - A - 3 462 658**
**US - A - 3 868 720**
**US - A - 4 151 542**

**The Concise Oxford Dictionary of Current English,
7.Auflage, Clarendon Press, Oxford 1983, Stichwort
"strip"**

(73) Patentinhaber: **Siemens Aktiengesellschaft Berlin und
München, Wittelsbacherplatz 2, D-8000 München 2 (DE)**

(72) Erfinder: **Tihanyi, Jenö, Dr. Ing., Windeckstrasse 1d,
D-8000 München 70 (DE)**

## Beschreibung

Beim Abschalten eines Leistungstransistors kann es zum lokalen Aufschmelzen des Halbleiterkörpers und damit zur Zerstörung des Transistors kommen, wenn der zulässige Betriebsbereich des Transistors überschritten wird. Dieser zulässige Betriebsbereich ist gekennzeichnet durch eine maximal zulässige charakteristische Schaltverlustleistung, die im Halbleiterkörper für eine bestimmte Zeit nicht überschritten werden darf. Die maximal zulässige Leistung wird dabei um so geringer, je länger sie im Halbleiterkörper in Wärme umgesetzt wird. Das lokale Aufschmelzen beim Überschreiten des zulässigen Betriebsbereichs hat seine Ursache vermutlich darin, dass beim Abschalten des Transistors der einsetzende, lateral unter dem Emitter fliessende Ausräumstrom den gesperrten Emitter-Basis-pn-Übergang wieder in Durchlassrichtung vorspannt, so dass ein hoher Strom bei gleichzeitig ansteigender Basis-Kollektor-Spannung fliessen kann. Diesen Schwierigkeiten ist man in der Vergangenheit bei der Konstruktion von Leistungstransistoren mit fingerförmigen Emitterzonen begegnet, bei denen der Lateralwiderstand unterhalb der Emitterzone entsprechend der geirngeren Breite der Finger vermindert ist. Der zulässige Betriebsbereich eines solchen Transistors ist damit, gemessen an einem Transistor mit gleicher, aber zusammenhängender Fläche, grösser.

Eine andere, bekannte Lösung zur Bewältigung dieses Problems besteht darin, einen Leistungstransistor in eine Vielzahl von auf einem einzigen Halbleiterkörper integrierten Teiltransistoren zu zerlegen, die über je einen Ballastwiderstand mit einer gemeinsamen Emitterelektrode verbunden sind. Eine solche Lösung ist z.B. in der Zeitschrift «Electronic Engineering», Juli 1983, Seiten 78/79, Fig. 15 dargestellt. Die Emitterzonen jedes Teiltransistors sind in eine allen Teiltransistoren gemeinsame Basiszone eingebettet. Der Ballastwiderstand jedes Teiltransistors wird durch eine in die Emitterzone eingebettete Zone entgegengesetzten Leitungstyps gebildet. Dadurch wird zwar ein direkter Kontakt des Ballastwiderstands mit der Basiszone vermieden, die lateralen Abmessungen der Emitterzone können damit aber eine gewisse Grösse nicht unterschreiten. Damit kann ein kräftiger, unter der Emitterzone lateral fliessender Strom den Basis-Emitter-pn-Übergang positiv vorspannen und der pn-Übergang beginnt zu emittieren.

Die Erfindung bezieht sich auf einen Leistungstransistor nach dem Oberbegriff des Anspruchs 1. Ein derartiger Leistungstransistor ist aus US-A-3 868 720 bekannt.

Der Erfindung liegt die Aufgabe zugrunde, einen solchen Leistungstransistor derart weiterzubilden, dass er besonders günstig hergestellt werden kann.

Die Erfindung ist dadurch gekennzeichnet, dass die Widerstandsschicht (5) aus dotiertem Halbleitermaterial besteht, dass das Halbleitermaterial höher dotiert ist als die mit der Widerstandsschicht kontaktierte Emitterzone (4) und dass die Widerstandschicht als Dotierstoffquelle für diese Emitterzone dient.

Weiterbildungen der Erfindung sind Gegenstand der Unteransprüche.

Die Erfindung wird anhand einiger Ausführungsbeispiele in Verbindung mit den Fig. 1 bis 4 näher erläutert. Es zeigen:

Fig. 1 den Schnitt durch ein charakteristisches Ausführungsbeispiel,

Fig. 2 eine Aufsicht auf eine erste Ausführungsform der Emitterzonen,

Fig. 3 die Aufsicht auf eine zweite Ausführungsform der Emitterzonen und

Fig. 4 die Aufsicht auf eine dritte Ausführungsform der Emitterzonen des Leistungstransistors.

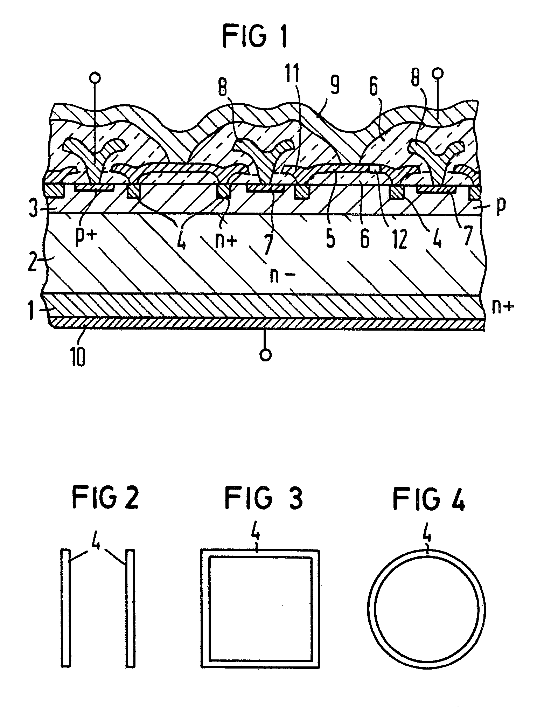

Der Leistungstransistor nach Fig. 1 weist ein hoch n-dotiertes Substrat 1 auf. Auf diesem sitzt eine schwach n-dotierte Kollektorzone 2, die beispielsweise durch epitaktisches Abscheiden aufgebracht wurde. Über der Kollektorzone sitzt eine Basiszone 3, die p-dotiert ist. In die Basiszone 3 sind Emitterzonen 4 planar eingebettet. Die Emitterzonen 4 sind streifenförmig ausgebildet, d.h., dass ihre Breite beträchtlich kleiner als ihre Längsausdehnung ist. Die Streifen können beispielsweise zehnmal länger als ihre Breite sein, es ist jedoch auch möglich, dass Verhältnis von Länge zu Breite grösser 100 zu machen. Die die Emitterzonen bildenden Streifen können gerade ausgeführt sein (Fig. 2), sie können ein Polygon, z.B. ein Rechteck, bilden (Fig. 3), ein Sechseck oder ein Achteck oder auch einen Ring mit kreisförmigem Querschnitt (Fig. 4). Sowohl das Polygon als auch der Ring kann offen oder geschlossen sein. Bevorzugte Ausführungsform für die Emitterzonen ist der Ring nach Fig. 4, da sich hier eine gleichmässige Feldstärkeverteilung entlang des Umfangs ergibt. Das Ausführungsbeispiel nach Fig. 1 wird daher im folgenden für eine ringförmige Emitterzone beschrieben.

Jede der ringförmigen Emitterzonen 4 ist von einer Widerstandsschicht 5 überdeckt, die den eingangs erwähnten Ballastwiderstand für einen Teiltransistor bildet. Diese Schicht ist eine dotierte Halbleiterschicht. Die Halbleiterschicht 5 ist auf einer Teilschicht einer Isolierschicht 6 angeordnet, die durch die waagrechten gestrichelten Linien begrenzt ist. Jede Halbleiterschicht 5 ist über ein in der genannten Teilschicht der Isolierschicht 6 angebrachtes Kontaktfenster mit der zugeordneten Emitterzone 4 verbunden. Alle Halbleiterschichten 5 sind ihrerseits elektrisch mit einer Emitterelektrode 9 verbunden. Durch die Emitterelektrode 9 werden die einzelnen Teiltransistoren einander parallel geschaltet. Zwischen den Teiltransistoren einander parallel geschaltet. Zwischen den Teiltransistoren sind Basiskontaktzonen 7 in die Basiszone 3 eingebettet. Sie weisen höhere Dotierung als die Basiszone 3 auf. Die Basiskontaktzonen sind mit Basiskontakten 8 kontaktiert, die untereinander parallel geschaltet sind. Sie bilden vorzugsweise ein zusammenhängendes Gitter, das unter der Emitterelektrode 9 liegt. Die andere Seite des Halbleiterkörpers, das vom Substrat 1 gebildet wird, ist mit einer Kollektorelektrode 10 versehen.

Die streifenförmigen Emitterzonen 4 können extrem schmal gehalten werden. Ihre Breite beträgt vorzugsweise zwischen 5 und 10 µm. Dem gegenüber kann der Durchmesser des Teiltransistors bzw. der Emitterzelle z.B. zwischen 50 und 100 µm liegen. Die den Ballastwiderstand bildende Halbleiterschicht 5 besteht im Ausführungsbeispiel aus n-dotiertem polykristallinem Silicium mit einer Dicke zwischen 0,2 und 1 µm. Der Schichtwiderstand des polykristallinen Siliciums liegt zwischen 10 und 150 Ohm/□, bevorzugt ist ein Wert von etwa 50 Ohm/□. Zweckmässigerweise wird die Halbleiterschicht 5 so hoch dotiert, dass sie einen positiven Temperaturkoeffizienten des Widerstands zeigt. Damit erhöht sich der Widerstand bei einer eventuell beginnenden Überlastung einer Transistorzelle derart, dass eine Gegenkopplung einsetzt, die den Basisstrom herabsetzt und dadurch weniger Emitterstrom fliessen lässt.

Die Halbleiterschicht 5 kann auch aus anderen Halbleitermaterialien z.B. aus Germanium, $A_3B_5$-Verbindungen usw. bestehen. Eine aus polykristallinem Silicium bestehende Halbleiterschicht 5 lässt sich mit Vorzug als Implantationsmaske für die Basiskontaktzonen 7 verwenden, wenn die Halbleiterschicht über den Rand der ringförmigen Emitterzone 4 herausragt und dort einen Überstand 11 bildet. Die Basiskontaktzonen 7 können dann auf einfache Weise z.B. durch Implantation mit Borionen erzeugt werden. Zur Erzeugung einer Basiskontaktzone mit einer Tiefe zwischen 0,1 und 1,5 µm beträgt die Dosis 0,1 bis $10 \cdot 10^{15}/cm^2$ und die Energie 10 bis 200 keV.

Die Emitterzonen 4 werden beosnders günstig hergestellt, dadurch dass auf die Basiszone 3 zunächst bis zur gestrichelten waagrechten Linie eine Isolierschicht 6 aufgebracht wird. Dann werden an den Stellen, wo die Emitterzonen 4 liegen sollen, Kontaktlöcher von der Fläche der Emitterzone 4 ausgeätzt. Anschliessend wird eine polyristalline Siliciumschicht abgeschieden, die höher dotiert ist als die Dotierung der zu erzeugenden Emitterzonen. Die Halbleiterschicht 5 dient dann als Dotierstoffquelle für die Emitterzone 4, wobei während einer üblichen Temperaturbehandlung Dotierstoffatome aus der Halbleiterschicht 5 im Bereich der erwähnten Kontaktfenster in die Basiszone 3 z.B. 0,5 bis 3 µm eindiffundieren.

Durch die Lage der Halbleiterschicht 5 auf der Isolierschicht 6, d.h. ausserhalb des Halbleiterkörpers, ist es möglich, die Emitterzonen sehr schmal auszuführen. Es ist ausserdem möglich, die Widerstände der Halbleiterschichten 5 abzugleichen, was auf einfache Weise, z.B. durch ein in eine der Halbleiterschichten 5 anzubringendes Loch 12, geschehen kann, wenn der Widerstand dieser Halbleiterschicht zu gering sein sollte. Die Dotierung der Zonen des Halbleiterkörpers kann auch komplementär sein. Die Halbleiterschichten 5 sind dann z.B. durch Bor zu dotieren.

Werden die Emitterzonen durch die Streifen nach Fig. 2 gebildet, so werden zweckmässigerweise jeweils zwei nebeneinanderliegende Streifen durch eine einzige Schicht 5 kontaktiert. Hierbei überdeckt die Schicht 5 dann mindestens einen Teil der zwischen den beiden Streifen liegenden Fläche der Basiszone 3.

## Patentansprüche

1. Leistungstransistor mit einem Halbleiterkörper, enthaltend mindestens eine Basiszone (3), mindestens eine Kollektorzone (2) und eine Vielzahl von Emitterzonen (4), deren Breite beträchtlich kleiner als ihre Längsausdehnung ist und die über je eine Wiederstandsschicht (5) mit einer Emitterelektrode (9) verbunden sind, wobei die Widerstandschicht auf einer auf dem Halbleiterkörper sitzenden Isolierschicht (6) angeordnet ist und die zugeordnete Emitterzone (4) durch ein in der Isolierschicht (6) angebrachtes Kontaktloch kontaktiert, dadurch gekennzeichnet, dass die Widerstandsschicht (5) aus dotiertem Halbleitermaterial besteht, dass das Halbleitermaterial höher dotiert ist als die mit der Widerstandsschicht kontaktierte Emitterzone (4) und dass die Widerstandsschicht als Dotierstoffquelle für diese Emitterzone dient.

2. Leistungstransistor nach Anspurch 1, dadurch gekennzeichnet, dass die Emitterzonen (4) durch je einen geraden Streifen gebildet sind.

3. Leistungstransistor nach Anspruch 1, dadurch gekennzeichnet, dass die Emitterzonen (4) durch je einen zu einem Ring geformten Streifen gebildet sind.

4. Leistungstransistor nach Anspruch 1, dadurch gekennzeichnet, dass die Emitterzonen (4) durch je einen zu einem Polygon geformten Streifen gebildet sind.

5. Leistungstransistor nach Anspruch 3, dadurch gekennzeichnet, dass die Widerstandsschicht (5) mindestens einen Teil der innerhalb des Rings liegenden Fläche des Halbleiterkörpers überdeckt.

6. Leistungstransistor nach Anspruch 4, dadurch gekennzeichnet, dass die Widerstandsschicht (5) mindestens einen Teil der innerhalb des Polygons liegenden Fläche des Halbleiterkörpers überdeckt.

7. Leistungstransistor nach Anpsruch 2, dadurch gekennzeichnet, dass je zwei der Streifen durch eine Widerstandsschicht (5) kontaktiert sind und dass die Widerstandsschicht mindestens einen Teil der zwischen den beiden Streifen liegenden Fläche des Halbleiterkörpers überdeckt.

8. Leistungstransistor nach einem der Ansprüche 1 bis 7, dadurch gekennzeichnet, dass das Halbleitermaterial der Widerstandsschicht (5) polykristallines Silicium ist.

9. Leistungstransistor nach einem der Ansprüche 1 bis 8, dadurch gekennzeichnet, dass in die Basiszone (3) Basiskontaktzonen (7) mit höherer Dotierung als die Basiszone eingebettet sind.

10. Leistungstransistor nach Anspruch 8 und 9, dadurch gekennzeichnet, dass jeweils eine der Basiskontaktzonen (7) zwischen zwei der Emitterzonen (4) angeordnet ist, dass die Widerstandsschichten über den Rand der Emitterzonen (4) hinausragen und als Implantationsmaske für die Basiskontaktzonen dienen.

## Revendications

1. Transistor de puissance possédant un corps semi-conducteur qui contient au moins une zone de base (3), au moins une zone de collecteur (2) et un grand nombre de zones d'émetteur (4) dont la largeur est nettement plus petite que leur étendue longitudinale et qui sont reliées chacune à travers une couche résistive (5) à une électrode d'émetteur (9), la couche résistive étant disposée sur une couche isolante (6) portée par le corps semi-conducteur et la couche résistive étant en contact avec la zone d'émetteur (4) coordonnée à travers un trou de contact formé dans la couche isolante (6), caractérisé en ce que la couche résistive (5) est formée de matériau semi-conducteur dopé, que ce matériau semi-conducteur est dopé plus fortement que la zone d'émetteur (5) en contact avec la couche résistive et que la couche résistive sert de source de dopant pour cette zone d'émetteur.

2. Transistor selon la revendication 1, caractérisé en ce que les zones d'émetteur (4) sont constituées chacune par un ruban droit.

3. Transistor selon la revendication 1, caractérisé en ce que les zones d'émetteur (4) sont constituées chacune par un ruban conformé en un anneau.

4. Transistor selon la revendication 1, caractérisé en ce que les zones d'émetteur (4) sont constituées chacune par un ruban conformé en un polygone.

5. Transistor selon la revendication 3, caractérisé en ce que la couche résistive (5) recouvre au moins une partie de l'aire du corps semi-conducteur située à l'intérieur de l'anneau.

6. Transistor selon la revendication 4, caractérisé en ce que la couche résistive (5) recouvre au moins une partie de l'aire du corps semi-conducteur située à l'intérieur du polygone.

7. Transistor selon la revendication 2, caractérisé en ce que deux rubans sont chaque fois en contact avec une couche résistive (5) et que cette couche résistive recouvre au moins une partie de l'aire du corps semi-conducteur située entre les deux rubans.

8. Transistor selon une des revendications 1 à 7, caractérisé en ce que le matériau semi-conducteur de la couche résistive (5) est du silicium polycristallin.

9. Transistor selon une des revendications 1 à 8, caractérisé en ce que des zones de contact de base (7) d'un dopage plus fort que la zone de base (3) sont disposées encastrées dans la zone de base.

10. Transistor selon les revendications 8 et 9, caractérisé en ce qu'une des zones de contact de base (7) est disposée chaque fois entre deux zones d'émetteur (4), et que les couches résistives (5) font saillie du bord des zones d'émetteur (4) et servent de masque d'implantation pour les zones de contact de base.

## Claims

1. A power transistor having a semiconductor body, containing at least one base zone (3), at least one collector zone (2) and a plurality of emitter zones (4) whose width is considerably smaller than their length and which are each connected through a respective resistive layer (5) to an emitter electrode (9), where the resistive layer is arranged on an insulating layer (6) located on the semiconductor body and contacts the assigned emitter zone (4) through a contact hole provided in the insulating layer (6), characterised in that the resistive layer (5) consists of doped semiconductor material; that the semiconductor material is doped to a higher level than the emitter zone (4) which is contacted by the resistive layer; and that the resistive layer serves as source of dopant for this emitter zone.

2. A power transistor as claimed in claim 1, characterised in that the emitter zones (4) are formed in each case by a straight strip.

3. A power transistor as claimed in claim 1, characterised in that the emitter zones (4) are formed in each case by a ring.

4. A power transistor as claimed in claim 1, characterised in that the emitter zones (4) are formed in each case by a strip forming a polygon.

5. A power transistor as claimed in claim 3, characterised in that the resistive layer covers at least a part of that surface of the semiconductor body which lies within the ring.

6. A power transistor as claimed in claim 4, characterised in that the resistive layer (5) covers at least a part of that surface of the semiconductor body which lies within the polygon.

7. A power transistor as claimed in claim 2, characterised in that two of the strips are in each case contacted by a resistive layer (5), and that the resistive layer covers at least a part of that surface of the semiconductor body which lies between the two strips.

8. A power transistor as claimed in one of claims 1 to 7, characterised in that the semiconductor material of the resistive layer (5) is polycrystalline silicon.

9. A power transistor as claimed in one of claimes 1 to 8, characterised in that base contact zones (7), doped to a higher level than the base zone (3), are embedded in the base zone.

10. A power transistor as claimed in claim 8 and 9, characterised in that one of the base contact zones (7) is in each case arranged between two of the emitter zones (4); and that the resistive layers (5) project beyond the edge of the emitter zones (4) and serve as an implantation mask for the base contact zones.

1/1

## FIG 1

## FIG 2    FIG 3    FIG 4